(19) **Europäisches Patentamt European Patent Office Office européen des brevets**

(11) **EP 4 557 537 B1**

(12) **FASCICULE DE BREVET EUROPEEN**

(45) Date de publication et mention de la délivrance du brevet:
**20.05.2026 Bulletin 2026/21**

(21) Numéro de dépôt: **24213431.0**

(22) Date de dépôt: **15.11.2024**

(51) Classification Internationale des Brevets (IPC):
*H01S 5/026* (2006.01)  *H01S 5/0625* (2006.01)
*H01S 5/065* (2006.01)  *H01S 5/10* (2021.01)
*H01S 5/125* (2006.01)  *H01S 5/14* (2006.01)
*H01S 5/40* (2006.01)  *H01S 5/02* (2006.01)

(52) Classification Coopérative des Brevets (CPC):
**H01S 5/026; H01S 5/021; H01S 5/06256;
H01S 5/0654; H01S 5/1007; H01S 5/125;
H01S 5/142; H01S 5/4068**

(54) **DISPOSITIF D ÉMISSION LASER INTÉGRÉ DE FORTE PUISSANCE**

**INTEGRIERTE HOCHLEISTUNGSLASEREMISSIONSVORRICHTUNG**

**HIGH POWER INTEGRATED LASER EMISSION DEVICE**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **17.11.2023 FR 2312669**

(43) Date de publication de la demande:
**21.05.2025 Bulletin 2025/21**

(73) Titulaire: **Commissariat à l'Energie Atomique et aux Energies Alternatives
75015 Paris (FR)**

(72) Inventeurs:
• **GUERBER, SYLVAIN
38054 Grenoble cedex 09 (FR)**
• **CHARBONNIER, BENOIT
38054 Grenoble cedex 09 (FR)**

(74) Mandataire: **INNOV-GROUP
209 Avenue Berthelot
69007 Lyon (FR)**

(56) Documents cités:
**US-A- 6 055 250**   **US-A1- 2017 163 008**
**US-A1- 2020 161 831**

**Description**

## DOMAINE TECHNIQUE

Le domaine technique de l'invention est l'optique intégrée et plus précisément la conception d'un circuit d'émission laser de forte puissance destiné à être utilisé, de façon non limitative, dans des applications de type LIDAR ou télécoms, ou d'autres applications photoniques.

## ART ANTERIEUR

Dans le domaine de l'optique on s'oriente vers des technologies permettant une fabrication et assemblage à grande échelle. En intégrant des composants optiques sur une même puce, il est possible de réduire les tailles et les coûts des systèmes tout en augmentant leurs performances.

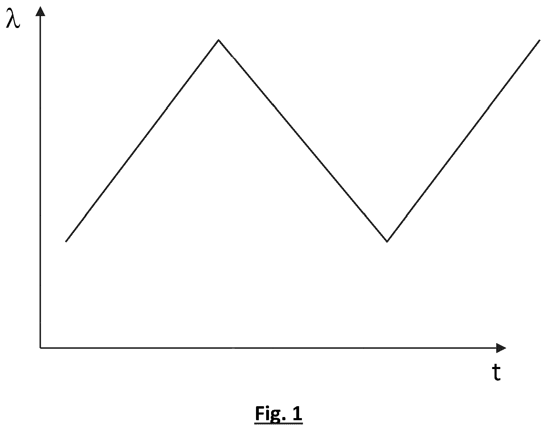

Dans le domaine des LIDARS, par exemple, l'usage de sources lasers modulées en longueur d'onde est courant. Selon les principes d'une onde modulée en fréquence de façon continue (FMCW - Frequency Modulated Continous Wave), il est possible d'effectuer une modulation continue de la longueur d'onde d'émission, par exemple selon une forme triangulaire, comme représenté sur la figure 1. Une partie d'un faisceau laser émis est prélevée, et dirigée vers un photodétecteur. Le faisceau laser réfléchi par une cible est également dirigé vers le photodétecteur. Le faisceau prélevé et le faisceau réfléchi étant cohérents, leur interférence peut être détectée par le photodétecteur, et se traduit par un écart fréquentiel directement proportionnel à la distance vis-à-vis de la cible. Le fonctionnement de tels dispositif est par exemple décrit dans la publication de C. Poulton « Coherent solid-state LIDAR with silicon photonic optical phased arrays ».

Le recours à des laser modulés en longueur d'onde peut également concerner le domaine des télécommunications optiques.

Qu'il s'agisse des applications de type LIDAR ou telecoms, on recherche des systèmes compacts ayant une puissance d'émission élevée, par exemple supérieure à 100 mW. Jusqu'à présent, les sources lasers intégrées sur une puce ne permettent pas l'obtention d'une telle puissance. Des systèmes hybrides permettent une augmentation de la puissance d'émission, par le biais d'une combinaison cohérente de faisceaux émis par différentes sources laser. Les publications Zhu.Y « Loss induced coherent combining in InP-Si3N4 hybrid platform", Sci. Rep., vol.8, n° 1, Art. N°1, Jan, 2018, ainsi que Zeng S. "Watt-level beam combined diode laser systems in a chip scale hybrid photonic platform",Optics Express, Vol. 30, N° 13/20, June 2022, décrivent des architectures hybrides, dans lesquelles plusieurs sources laser sont rapportées contre une puce photonique. Les faisceaux émis par chaque source sont combinés, dans le substrat, de façon à obtenir un faisceau de forte puissance. Cependant, de telles architectures présentent l'inconvénient d'un coût de fabrication élevé, du fait de l'assemblage qu'il est nécessaire d'établir, entre chaque source laser et le substrat. Une autre difficulté est l'alignement entre chaque source laser et le substrat, qui peut être délicat et engendrer des pertes.

Le document US2020/161831 décrit une source laser destinée à émettre une longueur d'onde en minimisant une dérive sous l'effet d'une variation de température.

L'invention décrite ci-après permet d'obtenir une source laser intégrée dans un substrat monolithique. En fonction des agencements, on obtient soit une source laser de forte puissance, soit plusieurs sources laser. De préférence, la source laser est modulée en longueur d'onde, de façon continue, ce qui permet une utilisation dans des Lidars.

## EXPOSE DE L'INVENTION

Un objet de l'invention est un dispositif d'émission laser, intégré dans un substrat, comportant :

- un guide d'onde principal, ménagé dans le substrat, et s'étendant à partir d'un réflecteur principal, le réflecteur principal étant configuré pour réfléchir une lumière dans une bande spectrale de réflexion ;
- plusieurs guides d'onde secondaires, optiquement reliés au guide d'onde principal, chaque guide d'onde secondaire s'étendant entre une extrémité de couplage, optiquement reliée au guide d'onde principal, et un réflecteur secondaire, chaque réflecteur secondaire étant configuré pour réfléchir la lumière dans la bande spectrale de réflexion;
- le dispositif étant caractérisé en ce que chaque guide d'onde secondaire est optiquement couplé à un milieu amplificateur, relié à un système de pompage laser, le milieu amplificateur étant propice à une émission laser sous l'effet d'un pompage exercé par le système de pompage laser, le milieu amplificateur étant disposé entre l'extrémité de couplage et le réflecteur secondaire dudit guide d'onde secondaire
- de façon que le dispositif forme autant de cavités de Fabry Pérot, que de guides d'onde secondaires, chaque cavité de Fabry-Pérot étant configurée pour permettre des réflexions multiples de la lumière à une même longueur d'onde de résonance, dans la bande spectrale de réflexion, entre le réflecteur principal et chaque réflecteur secondaire ;
- le dispositif comportant un extracteur, pour extraire la lumière du dispositif, à la longueur d'onde de résonance, ladite longueur d'onde de résonance formant une longueur d'onde d'émission du dispositif.

Selon un mode de réalisation, le réflecteur principal ou chaque réflecteur secondaire est réglable, de façon à moduler la bande spectrale de réflexion.

Selon une possibilité, la bande spectrale de réflexion du réflecteur principal est réglable, le réflecteur principal étant un miroir de Bragg, couplé à un modulateur configuré pour moduler un indice de réfraction dans ledit miroir de Bragg. Chaque réflecteur secondaire peut réfléchir la lumière dans une bande spectrale de réflexion secondaire fixe et plus large que la bande spectrale de réflexion du réflecteur principal, et contenant cette dernière.

Selon une possibilité, la bande spectrale de réflexion de chaque réflecteur secondaire est réglable, chaque réflecteur secondaire étant un miroir de Bragg, couplé à un modulateur configuré pour moduler un indice de réfraction dans ledit miroir de Bragg. Le réflecteur principal peut réfléchir la lumière dans une bande spectrale de réflexion fixe et plus large que la bande spectrale de réflexion de chaque réflecteur secondaire, et contenant cette dernière.

De préférence, au moins un guide d'onde secondaire comporte un modulateur de phase secondaire, configuré pour moduler un indice de réfraction le long d'une partie dudit guide d'onde secondaire, le modulateur de phase secondaire étant disposé entre l'extrémité de couplage dudit guide d'onde secondaire et le réflecteur secondaire dudit guide d'onde secondaire, de façon à moduler un chemin optique dans ledit guide d'onde secondaire.

De préférence, chaque guide d'onde secondaire comporte un modulateur de phase secondaire, configuré pour moduler un indice de réfraction le long d'une partie dudit guide d'onde secondaire, le modulateur de phase secondaire étant disposé entre l'extrémité de couplage dudit guide d'onde secondaire et le réflecteur secondaire dudit guide d'onde secondaire, de façon à moduler un chemin optique dans chaque guide d'onde secondaire.

Le guide d'onde principal peut comporter un modulateur de phase principal, configuré pour moduler un indice de réfraction le long d'une partie du guide d'onde principal, le modulateur de phase principal étant disposé entre chaque guide d'onde secondaire et le réflecteur principal, de façon à moduler la longueur d'onde de résonance de chaque cavité de Fabry-Pérot du dispositif.

Selon une possibilité :

- le réflecteur principal réfléchit plus de 90% de la lumière, dans la bande spectrale de réflexion;
- chaque réflecteur secondaire transmet au moins 20% de la lumière, dans la bande spectrale de réflexion, de façon que le réflecteur secondaire forme l'extracteur du dispositif.

Selon une possibilité :

- chaque réflecteur secondaire réfléchit plus de 90% de la lumière, dans la bande spectrale de réflexion;
- le réflecteur principal transmet au moins 20% dans la bande spectrale de réflexion, de façon que le réflecteur principal forme l'extracteur du dispositif.

Le guide d'onde principal peut être formé par un premier matériau, et entouré d'un premier matériau auxiliaire, dont l'indice de réfraction est inférieur à l'indice de réfraction du premier matériau.

Chaque guide d'onde secondaire peut être est formé par un deuxième matériau, et entouré d'un deuxième matériau auxiliaire, dont l'indice de réfraction est inférieur à l'indice de réfraction du deuxième matériau.

Selon une possibilité :

- le premier matériau est identique au deuxième matériau ;
- le premier matériau auxiliaire est identique au deuxième matériau auxiliaire.

Selon une possibilité :

- le premier matériau et le deuxième matériau sont Si ;
- le premier matériau auxiliaire au deuxième matériau auxiliaire sont SiO2.

Selon une possibilité :

- le premier matériau est SiN ;
- le deuxième matériau est Si ;
- le premier matériau auxiliaire est identique au deuxième matériau auxiliaire.

De préférence, le guide d'onde principal et au moins un guide d'onde secondaire, ou chaque guide d'onde secondaire, sont formés dans un même substrat, chaque milieu amplificateur étant reporté sur ledit substrat.

L'invention sera mieux comprise à la lecture de l'exposé des exemples de réalisation présentés, dans la suite de la description, en lien avec les figures listées ci-dessous.

## FIGURES

La figure 1 représente un exemple de modulation continue de la longueur d'onde. L'axe des ordonnées correspond à la longueur d'onde et l'axe des abscisses correspond au temps.
La figure 2 montre un premier mode de réalisation.
Les figures 3A et 3B schématisent une coupe de substrat au niveau du matériau actif.
La figure 4A schématise une bande spectrale de réflexion d'un réflecteur principal étroite et réglable, incluse dans la bande spectrale de réflexion large d'un réflecteur secondaire. On a également représenté l'énergie lumineuse propagée à l'intérieur de la cavité de Fabry-Pérot formée par le réflecteur principal et le réflecteur secondaire.

La figure 4B montre une configuration dans laquelle la bande spectrale de réflexion du réflecteur secondaire est confondue avec une longueur d'onde de résonance de la cavité de Fabry-Pérot.

La figure 4C montre une configuration selon laquelle, par rapport à la figure 4B, la bande spectrale de réflexion du réflecteur secondaire est modifiée.

La figure 4D montre une configuration selon laquelle, par rapport à la figure 4C, la longueur d'onde de résonance de la cavité de Fabry-Pérot est modifiée.

La figure 5 schématise un deuxième mode de réalisation.

## EXPOSE DE MODES DE REALISATION PARTICULIERS

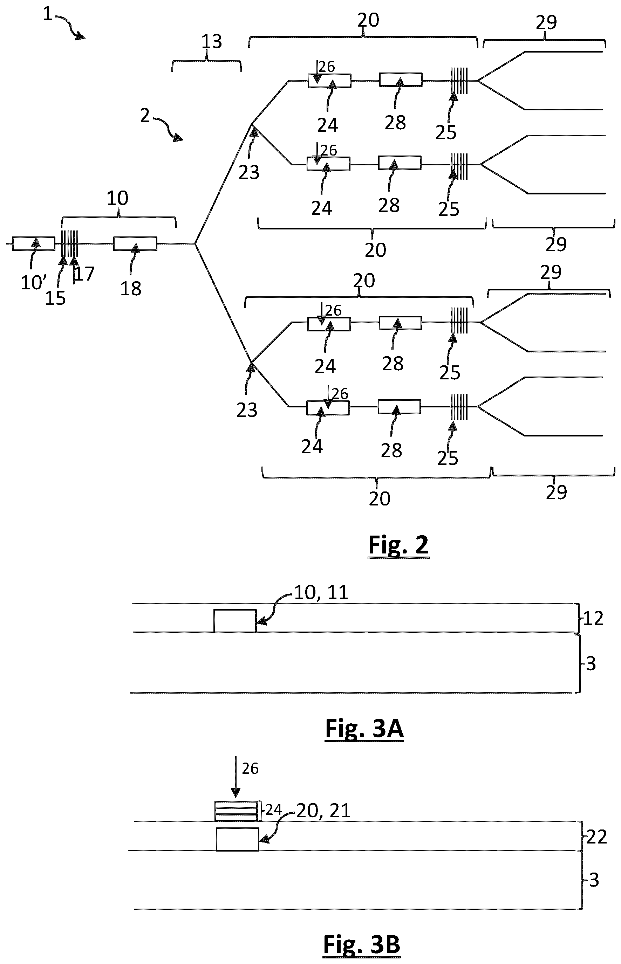

La figure 2 schématise un premier mode de réalisation de dispositif d'émission laser 1 selon l'invention. Le dispositif 1 est formé dans un substrat monolithique 2. La figure 2 représente une vue en coupe du dispositif, dans le plan du substrat. Le substrat 2 est par exemple de type SOI (Silicon on Insulator - Silicium sur Isolant). Le SOI est un substrat bien connu de la microélectronique, mais il est également très utilisé dans la fabrication de circuits optiques intégrés. Le silicium est transparent aux longueurs d'onde télécoms (1.3 $\mu$m - 1.5 $\mu$m), et le fort contraste d'indice avec son oxyde ($n_{Si}$ = 3.51 - $n_{SiO2}$ = 1.45 soit $\Delta n = n_{Si} - n_{SiO2}$ = 2) le rend adapté à des fonctions passives compactes : miroirs, guides d'onde, cavités résonantes. De plus, les procédés de fabrication actuels sont maîtrisés et permettent la réalisation de substrats de grande taille.

D'autres types de de substrats peuvent être utilisés, par exemple de type SiNOI (acronyme de Nitrure de silicium sur isolant) ou LNOI (acronyme de Niobate de Lithium sur isolant).

Le dispositif comporte un guide d'onde principal 10, ménagé dans le substrat, et s'étendant à partir d'un réflecteur principal 15, configuré pour réfléchir une longueur d'onde d'intérêt. Dans les exemples décrits, le réflecteur principal 15 est un miroir de Bragg, dit miroir de Bragg principal. D'autres types de réflecteurs, par exemple des boucles de Sagnac, sont envisageables. Le guide d'onde principal 10 est formé d'un premier matériau 11, en l'occurrence Si, autour duquel s'étend un premier matériau auxiliaire 12, en l'occurrence SiO₂. D'autres variantes sont décrites par la suite.

Le guide d'onde principal 10 est formé par des techniques classiques de photolithographie / gravure. Il est typiquement réalisé par gravure de la couche de silicium superficielle d'un wafer (plaque) SOI, cette dernière étant au contact d'une couche d'oxyde 3. Le guide d'onde de Si résultant de la gravure est ensuite recouvert d'une couche supérieure d'un matériau 12 d'indice plus faible, par exemple SiO₂. La couche supérieure peut être aminci et faire l'objet d'une planarisation. L'épaisseur de la couche supérieure peut être ramenée à 100 nm. Le canal est disposé sur la couche de SiO₂ 3. Un exemple de géométrie du canal est décrite par la suite, en lien avec les figures 3A et 3B. La hauteur du guide d'onde 10 est typiquement comprise entre 220 et 500nm, et sa largeur peut varier entre 100nm et 5$\mu$m.

De façon connue en soi, le miroir de Bragg principal 15 est formée d'une alternance périodique de deux matériaux ayant respectivement des indices de réfraction différents. La variation périodique de l'indice génère un ensemble de réflexions qui s'additionnent lorsqu'elles sont en phase. Dans cet exemple, le miroir de Bragg principal 15 est formé en réalisant une gravure partielle du silicium puis dépôt de SiO₂. La périodicité des zones gravées détermine une bande spectrale de réflexion, à laquelle le miroir de Bragg réfléchit la lumière, la période étant de l'ordre de quelques centaines de nanomètres. Le nombre de périodes est typiquement de plusieurs dizaines à plusieurs centaines voire milliers.

Dans cet exemple :

- le miroir de Bragg principal 15 est un miroir présentant une bande spectrale de réflexion étroite, la largeur à mi-hauteur de la bande spectrale de réflexion étant par exemple inférieure à 1 nm. La bande spectrale de réflexion est centrée sur la longueur d'onde d'intérêt $\lambda_i$.
- le miroir de Bragg principal 15 est un miroir total, dans le sens où il réfléchit la quasi-totalité de la lumière dans la bande spectrale de réflexion. Par quasi-totalité, on entend plus de 90%, voire plus de 95%, voire plus de 99%.
- le miroir de Bragg principal 15 est réglable, la bande spectrale de réflexion étant variable. La variation de la bande spectrale de réflexion est obtenue par une modulation des indices de réfraction, sous l'effet d'un modulateur 17, au niveau des matériaux formant le miroir de Bragg. Une telle modulation peut être obtenue par une variation locale de la température, le modulateur du miroir de Bragg 17 étant alors une résistance chauffante. La modulation peut également être obtenue par une injection locale de charges au niveau du miroir de Bragg. En effet, l'indice de réfraction d'un matériau semiconducteur dépend de la densité de charge. Sur la figure 2, le modulateur 17 du miroir de Bragg principal est matérialisé par une flèche.

Le dispositif 1 comporte plusieurs guides d'onde secondaires 20, dont la structure est de préférence, mais non nécessairement, identique à celle du guide d'onde principal 10 : même matériau, mêmes dimensions. D'une façon générale, chaque guide d'onde secondaire 20 est formé d'un deuxième matériau 21, en l'occurrence Si, autour duquel s'étend un deuxième matériau auxiliaire 22, en l'occurrence SiO₂.

Dans cet exemple, le dispositif 1 comporte quatre guides d'onde secondaires 20. Le nombre de guides d'onde secondaires peut être compris entre 2 et 10, voire plusieurs dizaines.

Chaque guide d'onde secondaire 20 s'étend entre une extrémité de couplage 23, destinée à être optiquement reliée au guide d'onde principal 10, et un réflecteur secondaire 25. Dans cet exemple, le réflecteur secondaire est un miroir de Bragg, dit miroir de Bragg secondaire. De préférence, les miroirs de Bragg secondaires sont identiques les uns des autres. Ils sont de préférence formés avec les mêmes matériaux que le miroir de Bragg principal 15, de façon à réfléchir la lumière dans la longueur d'onde d'intérêt définie par le miroir de Bragg principal 15. De préférence, la bande spectrale de réflexion de chaque miroir de Bragg secondaire 25 est identique, ou plus large que celle du réflecteur principal, et comporte la bande spectrale de réflexion du réflecteur principal 15. Dans cet exemple :

- chaque miroir de Bragg secondaire 25 est un miroir présentant une bande spectrale de réflexion large, la largeur à mi-hauteur de la bande spectrale de réflexion étant par exemple supérieure ou égale à 10 nm.
- chaque miroir de Bragg secondaire 25 est un miroir partiel, dans le sens où il réfléchit que partiellement la lumière dans la bande spectrale de réflexion. Par partiellement, on entend moins de 80%, voire moins de 50%, par exemple 40%. La lumière non réfléchie est transmise vers un circuit photonique. Par exemple, chaque miroir de Bragg secondaire 25 est connecté à l'une des entrées d'un réseau optique phasé (Optical Phased Array, OPA) qui permet, dans le cadre d'un système LiDAR, de réaliser le balayage du faisceau dans l'espace. Les miroirs de Bragg secondaires forment l'extracteur de lumière du dispositif.

La longueur de chaque miroir de Bragg peut être comprise entre quelques centaines de microns et plusieurs millimètres.

Il va de soi que la bande spectrale de réflexion du miroir de Bragg principal s'étend dans la bande spectrale de réflexion de chaque miroir de Bragg secondaire. On obtient ainsi des réflexions d'au moins une longueur d'onde d'intérêt $\lambda_i$, qui correspond à l'intersection de la bande spectrale de réflexion du miroir de Bragg principal et de chaque miroir de Bragg secondaire.

Entre le guide d'onde principal 10 et chaque guide d'onde secondaire 20, s'étendent des guides d'onde de transmission 13, dont la fonction est d'assurer un couplage optique entre le guide d'onde principal 15 et chaque guide d'onde secondaire 25. Un coupleur est utilisé au niveau de chaque extrémité de couplage 23 pour connecter/combiner les faisceaux issus des différents guides secondaires 20 vers le guide d'onde principal 10. Le coupleur peut être par exemple un coupleur directionnel ou un interféromètre multimode (MMI - Multi-

Mode inteferometer).

Chaque guide d'onde secondaire 20 forme, avec le guide d'onde principal 10, une cavité de Fabry-Pérot, permettant des réflexions successives de la lumière dans la longueur d'onde d'intérêt $\lambda_i$. La longueur d'onde d'intérêt $\lambda_i$ doit également correspondre à une longueur d'onde de résonance $\lambda_r$ de chaque cavité de Fabry-Pérot, comme décrit par la suite. Dans cet exemple, la longueur d'onde d'intérêt $\lambda_i$ est définie par le miroir de Bragg ayant la bande spectrale de réflexion la plus étroite. Il s'agit ici du miroir de Bragg principal 15. On observe que le dispositif permet une formation d'autant de cavités de Fabry-Pérot que de guides d'onde secondaires 20. Chaque cavité de Fabry-Pérot est formée par le guide d'onde principal 10 et un guide d'onde secondaire 20.

Un aspect important de l'invention est que chaque guide d'onde secondaire est optiquement couplé à un milieu d'amplification 24. Le milieu d'amplification 24, ou milieu actif, est un milieu émetteur de lumière laser sous l'effet d'un pompage. Il peut par exemple s'agir de couches de matériaux III-V formées en regard du guide d'onde secondaire 20.

La lumière générée par le milieu d'amplification 24 est injectée dans le guide d'onde secondaire 20 auquel il est optiquement couplé. Le milieu d'amplification 24 peut être séparé du guide d'onde secondaire 20 par une couche de collage de faible indice. Il est connu que des assemblages de matériaux III-V de type Al-GaAs/GaAs permettent une émission dans la gamme 600-800 nm, que des assemblages de matériaux III-V InGaAsP/InP permettent une émission dans la gamme 1300/1500 nm.

La couche d'amplification 24 est réalisée par un report, sur le substrat, d'une épitaxie laser III-V, permettant la formation de quelques microns de couches actives. Cet empilement est ensuite gravé pour former un guide d'onde au-dessus du guide photonique 20, lui-même étant également optimisé pour faciliter le transfert de lumière vers/depuis le guide III-V. Le report de couches de matériaux III-V sur un guide d'onde Si formé sur un substrat de type SOI est par exemple décrit dans Roelkens G. « III-V/silicon photonics for on-chip and inter-chip optical interconnect », Laser Photonics Rev. 4 N° 6, 751-779 (2010).

Les figures 3A et 3B schématisent des vues en coupe du substrat 2 respectivement au niveau du guide d'onde principal 10 et au niveau du guide d'onde secondaire 20. La figure 3B schématise une vue en coupe d'un milieu d'amplification 24. Le milieu d'amplification est configuré pour être couplé à un système de pompage 26. Ce dernier est actionné pour obtenir une inversion de population des porteurs de charge dans le matériau actif. Il peut s'agir d'un pompage optique, auquel cas l'inversion résulte d'une absorption d'un faisceau laser de pompe. De préférence, il peut s'agir d'un pompage électrique, permettant une injection de porteurs de charge par l'intermédiaire d'un courant dans une diode p-i-n- dont la zone i (intrinsèque) est formée par le matériau actif. Le pompage électrique est plus simple à mettre en œuvre.

Le milieu amplificateur 24 est disposé entre l'extrémité de couplage 23 et le miroir de Bragg secondaire 25. Cela permet une émission de lumière laser, à la longueur d'onde d'intérêt, qui est ensuite amplifiée par la cavité de Fabry Pérot, car chaque milieu amplificateur 24 est disposé entre deux miroirs de Bragg : le miroir de Bragg principal 15 et un miroir de Bragg secondaire 25.

Le dispositif d'émission 1 permet une émission d'une lumière laser de puissance élevée et distribuée spatialement, l'émission résultant de la transmission de chaque miroir de Bragg secondaire 25. Dans l'exemple représenté, des guides d'onde d'émission 29 permettent l'émission de la lumière à partir du dispositif. Comme précédemment décrit, la réflexion par les miroirs de Bragg secondaires 25 est partielle. La partie de la lumière non réfléchie est transmise. Chaque miroir de Bragg secondaire 25 est disposé entre un guide d'onde secondaire 20 et au moins un guide d'onde d'émission 29. Les ondes lumineuses respectivement émises par chaque guide d'onde secondaire 20 sont cohérentes, à la longueur d'onde d'intérêt.

Le recours à un modulateur du miroir de Bragg principal 17 permet de piloter une variation de la longueur d'onde d'émission du dispositif. Une unité de commande 30 permet de commander le modulateur 17, de façon à contrôler la bande spectrale de réflexion du miroir principal 15.

Chaque cavité de Fabry-Pérot est définie par des longueurs d'onde de résonance, définies par la relation :

$$\lambda_r = \frac{2Ln}{m}$$

Où

- $\lambda_r$ est la longueur d'onde de résonance ;
- $L$ est la longueur de la cavité Fabry-Perot ;
- $n$ est l'indice effectif du guide d'onde formé par le guide d'onde principal 10, le guide de transition 13 et le guide d'onde secondaire 20 :
- $m$ est un entier désignant un mode de résonance.

Afin d'obtenir une variation continue de la longueur d'onde d'émission du dispositif, il est avantageux que le dispositif comporte, dans chaque cavité de Fabry-Pérot, au moins un modulateur, dit modulateur de phase, de façon à moduler la longueur d'onde de résonance $\lambda_r$ pour que cette dernière corresponde à la longueur d'onde d'intérêt $\lambda_i$ réfléchie par les miroirs de Bragg.

Dans chaque cavité Fabry-Pérot, au moins un des réflecteurs est configuré de façon à n'adresser qu'un pic de résonance.

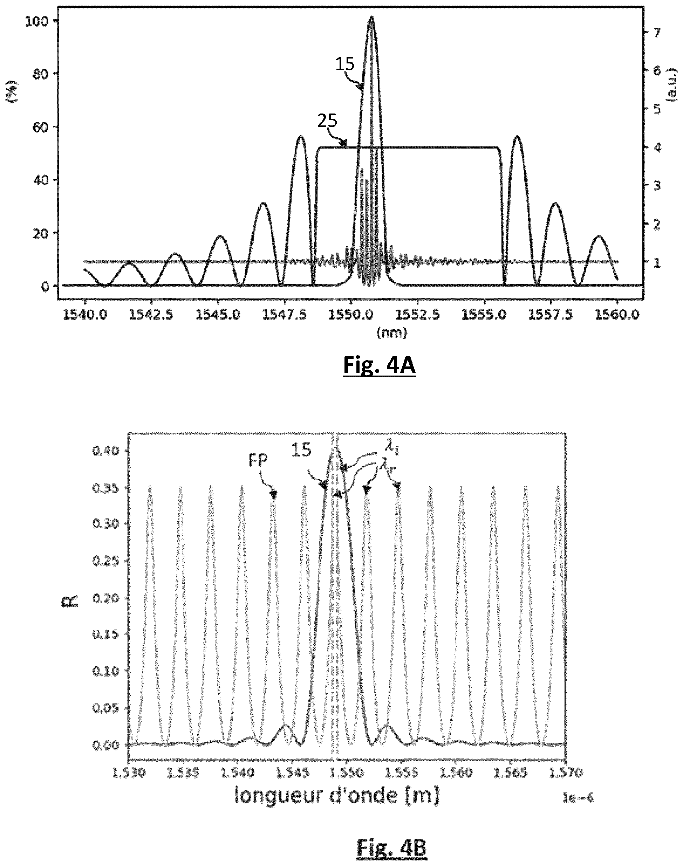

Les figures 4A à 4D illustrent une variation de la longueur d'onde d'émission du dispositif. Sur la figure 4A, on a représenté la bande spectrale de réflexion du miroir de Bragg principal 15 ainsi que la bande spectrale de réflexion de chaque miroir de Bragg secondaire 25. On observe que le miroir de Bragg principal 15 réfléchit de l'ordre de 100% de la lumière, selon une bande spectrale étroite, tandis que chaque miroir de Bragg secondaire 25 réfléchit de l'ordre de 50% de la lumière, selon une bande spectrale large, comportant la bande spectrale étroite du miroir de Bragg principal 15. Sur la figure 4A, l'axe des ordonnées de gauche est la réflectance (%), et l'axe des abscisses est la longueur d'onde (nm). On a également représenté une intensité de la lumière se propageant dans la cavité de Fabry-Pérot formée par le miroir de Bragg principal 15 et par le miroir de Bragg secondaire 25 en différentes longueurs d'onde (axe des ordonnées de droite unité arbitraire).

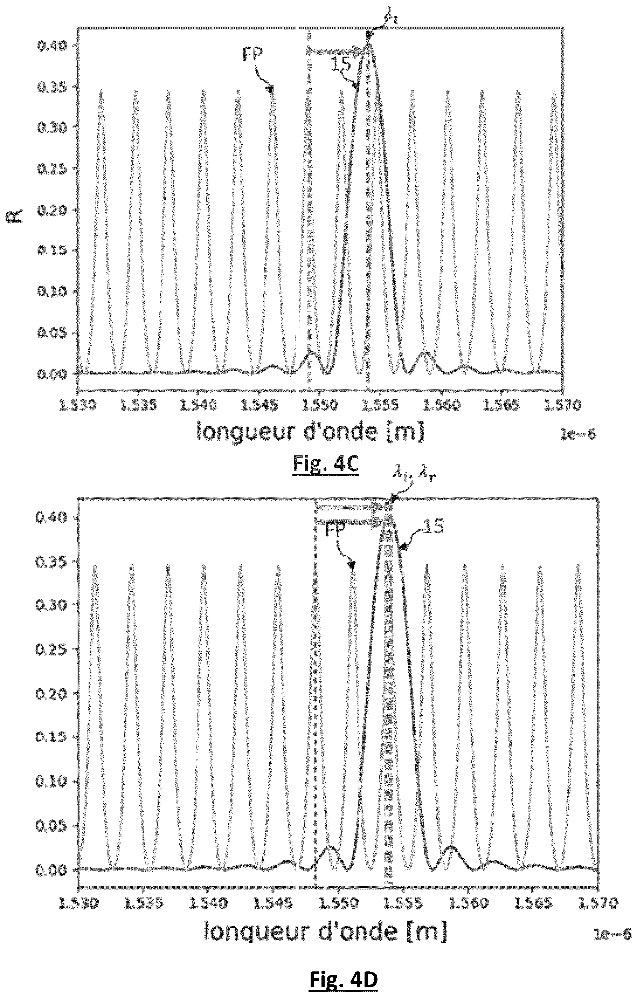

Sur la figure 4B, on a représenté la bande spectrale du miroir de Bragg principal 15, centré sur une longueur d'onde d'intérêt $\lambda_i$ proche de 1550 nm. On a également représenté, sur la courbe référencée FP, des longueurs d'onde de résonance $\lambda_r$ de chaque cavité de Fabry-Pérot. Dans l'exemple de la figure 4B, la longueur d'onde d'intérêt $\lambda_i$ correspond à une longueur d'onde de résonance $\lambda_r$ et à la longueur d'onde d'émission du dispositif. Sur la figure 4B, l'axe des ordonnées de gauche est la réflectance (%), et l'axe des abscisses est la longueur d'onde (m) Sur la figure 4C, on a représenté un décalage de la bande spectrale du miroir de Bragg principal 15. La longueur d'onde d'émission du dispositif correspond à une longueur d'onde de résonance $\lambda_r$ faisant partie de la bande spectrale de réflexion du miroir de Bragg, soit 1555 nm. Cette longueur d'onde correspond à la longueur d'onde de résonance de la cavité de Fabry-Pérot incluse dans la bande spectrale de réflexion. On observe alors une variation discrète de la longueur d'onde d'émission, avec un saut passant d'environ 1548 nm (figure 4B) à 1555 nm (figure 4C). Cela permet de modifier la longueur d'onde d'émission du dispositif, selon des valeurs discrètes. La longueur d'onde d'émission du dispositif correspond alors à une longueur d'onde de résonance présente dans la bande spectrale de réflexion du miroir de Bragg principal. Sur la figure 4C, l'axe des ordonnées de gauche est la réflectance (%), et l'axe des abscisses est la longueur d'onde (m). Les pointillés représentent les maximas des bandes spectrales de réflexion du miroir de Bragg principal respectivement avant et après le décalage.

Afin d'obtenir une variation continue de la longueur d'onde d'émission du dispositif, il est avantageux d'accompagner la variation de la bande spectrale de réflexion du miroir de Bragg 15 par une variation progressive de longueurs d'ondes de résonance $\lambda_r$ de la cavité Fabry Perot, comme représenté sur la figure 4D. Cela permet qu'une longueur d'onde de résonance $\lambda_r$ corresponde toujours à un maximum de la bande spectrale de réflexion du miroir de Bragg 15.

La variation de la longueur d'onde de réso-

nance $\lambda_r$ de chaque cavité de Fabry Perot du dispositif peut être obtenue en disposant un modulateur, dit modulateur de phase principal 18, au niveau du guide d'onde principal 10. Le modulateur de phase principal 18 est configuré pour faire varier l'indice de réfraction du guide d'onde principal 10. La variation de l'indice de réfraction peut être obtenue par échauffement localisé, ou par injection de charges. Le modulateur de phase principal 18 peut s'étendre selon une longueur comprise entre quelques centaines de microns et quelques millimètres.

Pour un guide en silicium, on estime que le décalage spectral peut atteindre 0.1 nm par K. Ainsi, en modifiant la température de 30°C, on peut couvrir un décalage spectral de 3 nm.

Des modulateurs de phase secondaires 28 peuvent être disposés dans chaque guide d'onde secondaire. Leur fonction est d'égaliser les chemins optiques dans chaque guide d'onde secondaire 20. A noter qu'il est également possible de moduler directement le courant (signal électrique de pompe) de chaque milieu amplificateur 24, ce qui produit une variation de charge dans l'amplificateur, et donc une modification du chemin optique. L'ajustement individuel permet de tenir compte de variabilités résultant de la fabrication de dispositif. La disposition de modulateurs de phase secondaires 28 dans chaque guide d'onde secondaire permet un ajustement individuel de chaque cavité de Fabry Pérot du dispositif, de façon que toutes les cavités aient, en chaque instant, la même longueur d'onde de résonance $\lambda_r$.

De façon alternative, le dispositif schématisé sur la figure 2 peut être tel que le miroir principal 15 soit fixe, et présente une large bande spectrale de réflexion, tandis que chaque miroir secondaire 25 soit variable, et de bande spectrale de réflexion étroite. Cependant, une telle configuration présente l'inconvénient d'avoir à commander simultanément plusieurs miroirs secondaires 25. La configuration représentée sur la figure 2 présente l'avantage de n'avoir à piloter qu'un seul miroir de Bragg, en l'occurrence le miroir de Bragg 15, simultanément avec la commande de la variation de la longueur d'onde de résonance de chaque cavité de Fabry Pérot, à l'aide du modulateur principal 18 et/ou des modulateurs secondaires 28.

Le dispositif comporte une photodiode 10', disposée à la sortie du miroir principal 10, et détectant des fuites de lumière transmises par ce dernier. Lorsque les chemins optiques des guides d'onde secondaires 20 sont égaux, chaque cavité Fabry-Pérot du dispositif permet l'émission de lasers verrouillés en phase, ce qui conduit à une augmentation importante de la puissance laser. Cette augmentation peut être détectée par la photodiode 10', traduisant le bon fonctionnement du dispositif. L'égalisation du chemin optique de chaque cavité Fabry-Pérot peut être réalisée de manière séquentielle, en réglant un par un chaque modulateur et chaque milieu amplificateur, pour maximiser la puissance collectée au niveau de la photodiode 10'.

Le dispositif décrit en lien avec la figure 2 est destiné à l'obtention d'une émission laser cohérente spatialement distribuée, au niveau de chaque guide d'émission 29 relié à un guide secondaire 20. Un avantage est que le guide de lumière transportant toute la puissance laser se limite au guide de lumière principal 10: la puissance maximale du laser est transportée selon une longueur relativement faible, typiquement sur quelques centaines de microns.

La concentration d'une forte densité de puissance dans un unique guide d'onde de Si peut entraîner une absorption du faisceau par effet de TPA (Two Photon Absorption). Cela peut conduire à une limitation de la puissance optique émise par le dispositif. Le fait de répartir le faisceau selon différents guides d'ondes secondaires 20 permet de réduire l'impact de ce type d'absorption.

Selon une possibilité, le guide d'onde principal 10, qui concentre la puissance laser, peut être formé à partir d'un matériau moins sensible à des phénomènes d'absorption de type TPA, et plus adapté au transport de forte puissance de lumière. Ainsi, le premier matériau 11, formant le guide d'onde principal, peut-être du SiN, qui ne présente pas de TPA aux longueurs d'onde d'intérêt.

Le dispositif décrit en lien avec la figure 2 permet d'augmenter la puissance laser, tout en multipliant les points d'émission. Il peut être utilisé dans des systèmes de type LIDAR, afin d'en augmenter la portée.

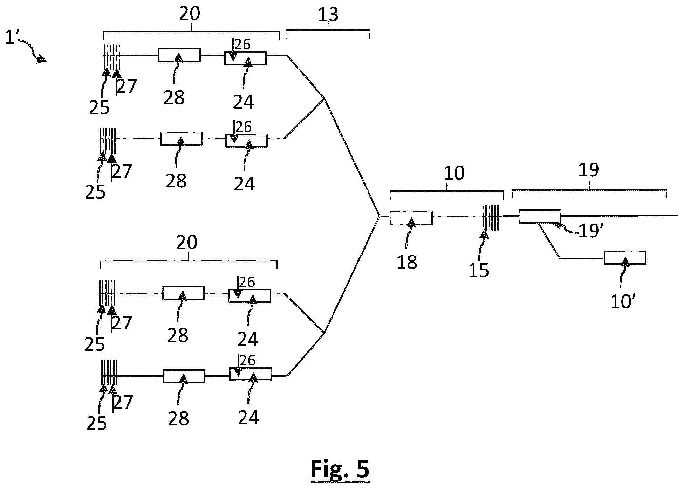

Selon une autre possibilité, représentée sur la figure 5, l'invention peut être mise en œuvre pour concentrer des ondes laser cohérentes, de façon à produire un faisceau de forte puissance. Sur la figure 5, les composants, non commentés ci-après, sont identiques à ceux décrits en lien avec la figure 2, et ont la même fonction.

Une différence notable par rapport au dispositif représenté sur la figure 2 est que chaque réflecteur secondaire 25 est totalement réfléchissant (coefficient de réflexion supérieur à 90%, voire proche de 100%), tandis que le réflecteur principal 15 est partiellement réfléchissant, le coefficient de réflexion étant inférieur à 80%, voire à 50%. Ainsi, l'émission de la lumière est effectuée par un guide d'onde d'émission 19, relié au guide d'onde principal 10. Le réflecteur principal 15 a une fonction d'extracteur de lumière. Le réflecteur principal 15 s'étend entre le guide d'onde principal 10 et le guide d'onde d'émission 19. L'émission de lumière est réalisée à partir de la lumière transmise par le miroir de Bragg principal. Un coupleur 19' permet de diriger un faible pourcentage de lumière, par exemple 1%, vers la photodiode 10'. Cette dernière est utilisée pour suivre la puissance laser émise par le dispositif. Elle permet de vérifier que le verrouillage de phase des différents lasers a été obtenu.

Quel que soit le mode de réalisation, le dispositif peut être utilisé pour émettre un faisceau laser de puissance élevée, sans nécessairement faire varier la longueur d'onde d'émission dans le temps. Dans ce cas, il n'est pas nécessaire qu'au moins un réflecteur, en l'occurrence le réflecteur principal, soit modulable. De même, il n'est pas nécessaire de moduler la fréquence de résonance des cavités de Fabry-Pérot. Le modulateur principal 18 n'est pas nécessaire. Le recours aux modulateurs secondaires 28 reste préférable, à des fins d'ajustement des chemins optiques dans chaque guide d'onde secondaire 20. Le dispositif peut être utilisé pour des applications de type calcul photonique, dans lequel on effectue des opérations mathématiques en formant des interférences destructives ou constructives entre plusieurs faisceaux laser cohérents. Une interférence constructive peut correspondre à une addition. Une interférence destructive correspond à une soustraction.

## Revendications

1. Dispositif d'émission laser (1, 1'), intégré dans un substrat (2), comportant :

   - un guide d'onde principal (10), ménagé dans le substrat, et s'étendant à partir d'un réflecteur principal (15), le réflecteur principal étant configuré pour réfléchir une lumière dans une bande spectrale de réflexion ;
   - plusieurs guides d'onde secondaires (20) , optiquement reliés au guide d'onde principal (10), chaque guide d'onde secondaire s'étendant entre une extrémité de couplage (13), optiquement reliée au guide d'onde principal (10), et un réflecteur secondaire (25), chaque réflecteur secondaire étant configuré pour réfléchir la lumière dans la bande spectrale de réflexion;
   - chaque guide d'onde secondaire (20) est optiquement couplé à un milieu amplificateur (24), relié à un système de pompage laser (26), le milieu amplificateur étant propice à une émission laser sous l'effet d'un pompage exercé par le système de pompage laser, le milieu amplificateur étant disposé entre l'extrémité de couplage (23) et le réflecteur secondaire (25) dudit guide d'onde secondaire
   
   de façon que le dispositif forme autant de cavités de Fabry Pérot, que de guides d'onde secondaires, chaque cavité de Fabry-Pérot étant configurée pour permettre des réflexions multiples de la lumière à une même longueur d'onde de résonance, dans la bande spectrale de réflexion, entre le réflecteur principal et chaque réflecteur secondaire ;
   - le dispositif comporte un extracteur (15, 25), pour extraire la lumière du dispositif, à la longueur d'onde de résonance, ladite longueur d'onde de résonance formant une longueur d'onde d'émission du dispositif;

   le dispositif étant **caractérisé en ce que**

   - les guides d'ondes secondaires définissent des chemins optiques égaux les uns des autres.

2. Dispositif selon la revendication 1, dans lequel le réflecteur principal ou chaque réflecteur secondaire est réglable, de façon à moduler la bande spectrale de réflexion.

3. Dispositif selon la revendication 2, dans lequel la bande spectrale de réflexion du réflecteur principal est réglable, le réflecteur principal étant un miroir de Bragg, couplé à un modulateur (17) configuré pour moduler un indice de réfraction dans ledit miroir de Bragg.

4. Dispositif selon la revendication 3, dans lequel le réflecteur secondaire réfléchit la lumière dans une bande spectrale de réflexion secondaire fixe et plus large que la bande spectrale de réflexion du réflecteur principal.

5. Dispositif selon la revendication 4, dans lequel la bande spectrale de réflexion de chaque réflecteur secondaire est réglable, chaque réflecteur secondaire étant un miroir de Bragg, couplé à un modulateur (27) configuré pour moduler un indice de réfraction dans ledit miroir de Bragg.

6. Dispositif selon la revendication 5, dans lequel le réflecteur principal réfléchit la lumière dans une bande spectrale de réflexion fixe et plus large que la bande spectrale de réflexion de chaque réflecteur secondaire.

7. Dispositif selon l'une quelconque des revendications précédentes, dans lequel au moins un guide d'onde secondaire (20) comporte un modulateur de phase secondaire (28), configuré pour moduler un indice de réfraction le long d'une partie dudit guide d'onde secondaire (25), le modulateur de phase secondaire étant disposé entre l'extrémité de couplage (23) dudit guide d'onde secondaire et le réflecteur secondaire (25) dudit guide d'onde secondaire, de façon à moduler le chemin optique dans ledit guide d'onde secondaire.

8. Dispositif selon la revendication 7, dans lequel chaque guide d'onde secondaire comporte un modulateur de phase secondaire, configuré pour moduler un indice de réfraction le long d'une partie dudit guide d'onde secondaire, le modulateur de phase secondaire étant disposé entre l'extrémité de couplage dudit guide d'onde secondaire et le réflecteur secondaire dudit guide d'onde secondaire, de façon à moduler le chemin optique dans chaque guide d'onde secondaire.

9. Dispositif selon l'une quelconque des revendications précédentes, dans lequel le guide d'onde principal comporte un modulateur de phase principal (18), configuré pour moduler un indice de réfraction le long d'une partie du guide d'onde principal, le modulateur de phase principal étant disposé entre chaque guide d'onde secondaire et le réflecteur principal, de façon à moduler la longueur d'onde de résonance de chaque cavité de Fabry-Pérot du dispositif.

10. Dispositif selon l'une quelconque des revendications précédentes, dans lequel

   - le réflecteur principal (15) réfléchit plus de 90% de la lumière, dans la bande spectrale de réflexion ;
   - chaque réflecteur secondaire (25) transmet au moins 20% de la lumière, dans la bande spectrale de réflexion, de façon que le réflecteur secondaire forme l'extracteur du dispositif.

11. Dispositif selon l'une quelconque des revendications 1 à 9, dans lequel

   - chaque réflecteur secondaire (25) réfléchit plus de 90% de la lumière, dans la bande spectrale de réflexion ;
   - le réflecteur principal transmet au moins 20% dans la bande spectrale de réflexion, de façon que le réflecteur principal forme l'extracteur du dispositif.

12. Dispositif selon l'une quelconque des revendications précédentes, dans lequel le guide d'onde principal est formé par un premier matériau (11), et entouré d'un premier matériau auxiliaire (12, 3), dont l'indice de réfraction est inférieur à l'indice de réfraction du premier matériau.

13. Dispositif selon l'une quelconque des revendications précédentes, dans lequel chaque guide d'onde secondaire (20) est formé par un deuxième matériau (21), et entouré d'un deuxième matériau auxiliaire (22, 3), dont l'indice de réfraction est inférieur à l'indice de réfraction du deuxième matériau.

14. Dispositif selon les revendications 12 et 13, dans lequel

   - le premier matériau est identique au deuxième matériau ;
   - le premier matériau auxiliaire est identique au deuxième matériau auxiliaire.

15. Dispositif selon l'une quelconque des revendications précédentes, dans lequel le guide d'onde principal et chaque guide d'onde secondaire sont formés dans un même substrat (2), chaque milieu amplificateur (24) étant reporté sur ledit substrat.

## Patentansprüche

1. Laseremissionsvorrichtung (1, 1'), die in ein Substrat (2) integriert ist, umfassend:

   - einen Hauptwellenleiter (10), der in dem Substrat ausgebildet ist und sich von einem Hauptreflektor (15) aus erstreckt, wobei der Hauptreflektor dazu ausgestaltet ist, ein Licht in einem Reflexionsspektralband zu reflektieren;
   - mehrere Sekundärwellenleiter (20), die optisch mit dem Hauptwellenleiter (10) verbunden sind, wobei sich jeder Sekundärwellenleiter zwischen einem Kopplungsende (13), das optisch mit dem Hauptwellenleiter (10) verbunden ist, und einem Sekundärreflektor (25) erstreckt, wobei jeder Sekundärreflektor dazu ausgestaltet ist, das Licht in dem Reflexionsspektralband zu reflektieren;
   - wobei jeder Sekundärwellenleiter (20) optisch mit einem Verstärkungsmedium (24) gekoppelt ist, das mit einem Laserpumpsystem (26) verbunden ist, wobei das Verstärkungsmedium für eine Laseremission unter der Wirkung eines von dem Laserpumpsystem ausgeübten Pumpens geeignet ist, wobei das Verstärkungsmedium zwischen dem Kopplungsende (23) und dem Sekundärreflektor (25) des Sekundärwellenleiters angeordnet ist, so dass die Vorrichtung ebenso viele Fabry-Pérot-Kavitäten wie Sekundärwellenleiter bildet, wobei jede Fabry-Pérot-Kavität dazu ausgestaltet ist, Mehrfachreflexionen des Lichts mit einer selben Resonanzwellenlänge in dem Reflexionsspektralband zwischen dem Hauptreflektor und jedem Sekundärreflektor zu ermöglichen;
   - wobei die Vorrichtung einen Extraktor (15, 25) umfasst, um das Licht aus der Vorrichtung mit der Resonanzwellenlänge zu extrahieren, wobei die Resonanzwellenlänge eine Emissionswellenlänge der Vorrichtung bildet;

   wobei die Vorrichtung **dadurch gekennzeichnet ist, dass**

   - die Sekundärwellenleiter zueinander gleiche optische Pfade definieren.

2. Vorrichtung nach Anspruch 1, wobei der Hauptreflektor oder jeder Sekundärreflektor einstellbar ist, so dass das Reflexionsspektralband moduliert wird.

3. Vorrichtung nach Anspruch 2, wobei das Reflexionsspektralband des Hauptreflektors einstellbar ist, wobei der Hauptreflektor ein Bragg-Spiegel ist, der mit einem Modulator (17) gekoppelt ist, der dazu ausgestaltet ist, einen Brechungsindex in dem Bragg-Spiegel zu modulieren.

4. Vorrichtung nach Anspruch 3, wobei der Sekundärreflektor das Licht in einem sekundären Reflexionsspektralband reflektiert, das fix und breiter als das Reflexionsspektralband des Hauptreflektors ist.

5. Vorrichtung nach Anspruch 4, wobei das Reflexionsspektralband jedes Sekundärreflektors einstellbar ist, wobei jeder Sekundärreflektor ein Bragg-Spiegel ist, der mit einem Modulator (27) gekoppelt ist, dazu ausgestaltet ist, einen Brechungsindex in dem Bragg-Spiegel zu modulieren.

6. Vorrichtung nach Anspruch 5, wobei der Hauptreflektor das Licht in einem Reflexionsspektralband reflektiert, das fix und breiter als das Reflexionsspektralband jedes Sekundärreflektors ist.

7. Vorrichtung nach einem der vorhergehenden Ansprüche, wobei mindestens ein Sekundärwellenleiter (20) einen Sekundärphasenmodulator (28) umfasst, der dazu ausgestaltet ist, einen Brechungsindex entlang eines Teils des Sekundärwellenleiters (25) zu modulieren, wobei der Sekundärphasenmodulator zwischen dem Kopplungsende (23) des Sekundärwellenleiters und dem Sekundärreflektor (25) des Sekundärwellenleiters angeordnet ist, so dass der optische Pfad in dem Sekundärwellenleiter moduliert wird.

8. Vorrichtung nach Anspruch 7, wobei jeder Sekundärwellenleiter einen Sekundärphasenmodulator umfasst, der dazu ausgestaltet ist, einen Brechungsindex entlang eines Teils des Sekundärwellenleiters zu modulieren, wobei der Sekundärphasenmodulator zwischen dem Kopplungsende des Sekundärwellenleiters und dem Sekundärreflektor des Sekundärwellenleiters angeordnet ist, so dass der optische Pfad in jedem Sekundärwellenleiter moduliert wird.

9. Vorrichtung nach einem der vorhergehenden Ansprüche, wobei der Hauptwellenleiter einen Hauptphasenmodulator (18) umfasst, der dazu ausgestaltet ist, einen Brechungsindex entlang eines Teils des Hauptwellenleiters zu modulieren, wobei der Hauptphasenmodulator zwischen jedem Sekundärwellenleiter und dem Hauptreflektor angeordnet ist, so dass die Resonanzwellenlänge jeder Fabry-Pérot-Kavität der Vorrichtung moduliert wird.

10. Vorrichtung nach einem der vorhergehenden Ansprüche, wobei

- der Hauptreflektor (15) mehr als 90 % des Lichts in dem Reflexionsspektralband reflektiert;
- jeder Sekundärreflektor (25) mindestens 20 % des Lichts in dem Reflexionsspektralband transmittiert, so dass der Sekundärreflektor den Extraktor der Vorrichtung bildet.

11. Vorrichtung nach einem der Ansprüche 1 bis 9, wobei

- jeder Sekundärreflektor (25) mehr als 90 % des Lichts in dem Reflexionsspektralband reflektiert;
- der Hauptreflektor mindestens 20 % in dem Reflexionsspektralband transmittiert, so dass der Hauptreflektor den Extraktor der Vorrichtung bildet.

12. Vorrichtung nach einem der vorhergehenden Ansprüche, wobei der Hauptwellenleiter durch ein erstes Material (11) gebildet wird und von einem ersten Hilfsmaterial (12, 3) umgeben ist, dessen Brechungsindex geringer als der Brechungsindex des ersten Materials ist.

13. Vorrichtung nach einem der vorhergehenden Ansprüche, wobei jeder Sekundärwellenleiter (20) durch ein zweites Material (21) gebildet wird und von einem zweiten Hilfsmaterial (22, 3) umgeben ist, dessen Brechungsindex geringer ist als der Brechungsindex des zweiten Materials ist.

14. Vorrichtung nach den Ansprüchen 12 und 13, wobei

- das erste Material mit dem zweiten Material identisch ist;
- das erste Hilfsmaterial mit dem zweiten Hilfsmaterial identisch ist.

15. Vorrichtung nach einem der vorhergehenden Ansprüche, wobei der Hauptwellenleiter und jeder Sekundärwellenleiter in einem selben Substrat (2) gebildet sind, wobei jedes Verstärkungsmedium (24) auf das Substrat übertragen wird.

**Claims**

1. Laser emission device (1, 1') integrated into a substrate (2), comprising:

- a primary waveguide (10), formed in the substrate, and extending from a primary reflector (15), the primary reflector being configured to reflect light in a reflection spectral band;
- a plurality of secondary waveguides (20), optically connected to the primary waveguide (10), each secondary waveguide extending between a coupling end (13), optically connected to the primary waveguide (10), and a secondary reflector (25), each secondary reflector being configured to reflect light in the reflection spectral band;

- each secondary waveguide (20) is optically coupled to a gain medium (24) connected to a laser-pumping system (26), the gain medium being conducive to laser emission under the effect of pumping exerted by the laser-pumping system, the gain medium being placed between the coupling end and (23) the secondary reflector (25) of the secondary waveguide so that the device forms as many Fabry-Pérot cavities as secondary waveguides, each Fabry-Pérot cavity being configured to allow multiple reflections of light at a given resonant wavelength, in the reflection spectral band, between the primary reflector and each secondary reflector;

- the device comprises an extractor (15, 25), for extracting light from the device, at the resonant wavelength, said resonant wavelength forming an emission wavelength of the device;

the device being **characterized in that**

- the secondary waveguides define optical path lengths that are equal to one another.

2. Device according to Claim 1, wherein the primary reflector or each secondary reflector is adjustable, so as to modulate the reflection spectral band.

3. Device according to Claim 2, wherein the reflection spectral band of the primary reflector is adjustable, the primary reflector being a Bragg mirror, coupled to a modulator (17) configured to modulate a refractive index in said Bragg mirror.

4. Device according to Claim 3, wherein the secondary reflector reflects light in a set secondary reflection spectral band wider than the reflection spectral band of the primary reflector.

5. Device according to Claim 4, wherein the reflection spectral band of each secondary reflector is adjustable, each secondary reflector being a Bragg mirror, coupled to a modulator (27) configured to modulate a refractive index in said Bragg mirror.

6. Device according to Claim 5, wherein the primary reflector reflects light in a set reflection spectral band wider than the reflection spectral band of each secondary reflector.

7. Device according to any one of the preceding claims, wherein at least one secondary waveguide (20) comprises a secondary phase modulator (28), configured to modulate a refractive index along a portion of said secondary waveguide (25), the secondary phase modulator being placed between the coupling end (23) of said secondary waveguide and the secondary reflector (25) of the secondary waveguide, so as to modulate an optical path length in said secondary waveguide.

8. Device according to Claim 7, wherein each secondary waveguide comprises a secondary phase modulator, configured to modulate a refractive index along a portion of said secondary waveguide, the secondary phase modulator being placed between the coupling end of said secondary waveguide and the secondary reflector of said secondary waveguide, so as to modulate an optical path length in each secondary waveguide.

9. Device according to any one of the preceding claims, wherein the primary waveguide comprises a primary phase modulator (18), configured to modulate a refractive index along a portion of the primary waveguide, the primary phase modulator being placed between each secondary waveguide and the primary reflector, so as to modulate the resonant wavelength of each Fabry-Pérot cavity of the device.

10. Device according to any one of the preceding claims, wherein:

- the primary reflector (15) reflects more than 90% of the light, in the reflection spectral band;
- each secondary reflector (25) transmits at least 20% of the light, in the reflection spectral band, so that the secondary reflector forms the extractor of the device.

11. Device according to any one of claims 1 to 9, wherein:

- each secondary reflector (25) reflects more than 90% of the light, in the reflection spectral band;
- the primary reflector transmits at least 20% in the reflection spectral band, so that the primary reflector forms the extractor of the device.

12. Device according to any one of the preceding claims, wherein the primary waveguide is formed by a first material (11), and surrounded by a first auxiliary material (12,3), the refractive index of which is lower than the refractive index of the first material.

13. Device according to any one of the preceding claims, wherein each secondary waveguide (20) is formed by a second material (21), and surrounded by a second auxiliary material (22,3), the refractive index of which is lower than the refractive index of the second material.

**14.** Device according to claims 12 and 13, wherein:

- the first material is identical to the second material;
- the first auxiliary material is identical to the second auxiliary material.

**15.** Device according to any one of the preceding claims, wherein the primary waveguide and each secondary waveguide are formed in the same substrate (2), each gain medium (24) being transferred to said substrate.

**Fig. 1**

**Fig. 2**

**Fig. 3A**

**Fig. 3B**

**Fig. 4A**

**Fig. 4B**

**Fig. 4C**

**Fig. 4D**

16

**Fig. 5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2020161831 A

**Littérature non-brevet citée dans la description**

- **C. POULTON**. *Coherent solid-state LIDAR with silicon photonic optical phased arrays*
- **ZHU.Y**. Loss induced coherent combining in InP-Si3N4 hybrid platform. *Sci. Rep.*, January 2018, vol. 8 (1)
- **ZENG S.** Watt-level beam combined diode laser systems in a chip scale hybrid photonic platform. *Optics Express*, 20 June 2022, vol. 30 (13)
- **ROELKENS G**. III-V/silicon photonics for on-chip and inter-chip optical interconnect. *Laser Photonics Rev.*, 2010, vol. 4 (6), 751-779